# FASCICULE DE BREVET EUROPEEN

(11) **EP 2 646 757 B1**
(45) Date de publication et mention de la délivrance du brevet: **31.07.2019**
(21) Numéro de dépôt: 11808671.9
(22) Date de dépôt: 29.11.2011
(51) Int. Cl.: H01L 31/048, H02S 10/40, H02S 40/22, H02S 40/34, F24S 25/50, H01L 31/042, F24S 20/70

(54) **PANNEAU SOLAIRE FLOTTANT ET INSTALLATION SOLAIRE CONSTITUEE D'UN ASSEMBLAGE DE TELS PANNEAUX**
SCHWIMMFÄHIGES SOLARPANEEL UND SOLARKRAFTWERK AUS EINER ANORDNUNG DERARTIGER PANEELE
BUOYANT SOLAR PANEL, AND SOLAR POWER PLANT CONSISTING OF AN ASSEMBLY OF SAID PANELS

(30) Priorité: 30.11.2010 FR 1059899
(43) Date de publication de la demande: 09.10.2013
(73) Titulaire: Afield Sustainable Innovations, 92160 Antony (FR)
(72) Inventeur: BERSANO, Giacomo, F-92160 Antony (FR); BOBBIO, Massimo, I-10156 Torino (IT)
(74) Mandataire: IPAZ
(86) Numéro de dépôt international: PCT/FR2011/052806
(87) Numéro de publication internationale: WO 2012/072941

(56) Documents cités:
- WO-A1-2008/125154
- JP-A- 2002 371 947
- JP-A- 2003 229 593
- JP-A- 2004 071 965
- KR-A- 20090 037 020
- US-A1- 2009 133 732

## Description

L'invention concerne le domaine des panneaux solaires suivant l'intitulé de la revendication 1 et en particulier des installations de panneaux en milieu aquatique selon la revendication 10. Par « panneau solaire » on entend d'une façon générale dans le texte ci-après un panneau de dimensions classiques de l'ordre de 1 à 3 m², aisément manipulable et transportable, pouvant offrir une puissance de l'ordre de 1,3 kW / m²
En dépit du développement actuel de l'énergie solaire, les contraintes foncières (coût du m²) et techniques (maçonnerie, fixation etc.) constituent des freins sévères au développement dans certaines régions ou certains milieux urbains. Les installations au sol ne sont pas compatibles avec d'autres utilisations du sol, par exemple l'agriculture. En outre, les installations solaires sont parfois décriées pour leur aspect qui peut altérer l'esthétique d'un paysage ou le rendu extérieur d'un bâtiment supportant des panneaux.

Le milieu aquatique offre une possibilité très prometteuse d'installation de tels panneaux solaires, tant en milieu marin que sur des lacs ou rivières : la surface est peu chère et non occupée par l'homme (ou très peu). On connaît déjà des concepts de panneaux solaires installés en milieu aquatique. Les dispositifs existants utilisent par exemple une ile artificielle de plusieurs dizaines ou même centaines de mètres de largeur ou un support flottant typiquement de plusieurs mètres de côté ou de diamètre sur lequel sont disposés une multitude de panneaux solaires classiques.. Ce type d'installation est lourd, peu commode à installer et forme un écran préjudiciable à la photosynthèse des fonds marins. De plus ce type d'installation présente une surface très exposée aux oiseaux qui peuvent se poser sur ces panneaux, à leurs déjections, ce qui engendre des dégradations rapides et/ou un entretien coûteux. L'entretien et la maintenance sont d'autant plus couteux que l'installation est moins accessible que sur la terre ferme.

Le document JP 2003 229593 décrit un panneau solaire solaire le préambule de la revendication 1.

Le but de la présente invention est de pallier tout ou partie des inconvénients précédents des panneaux solaires connus et des installations correspondantes.

A cet effet, l'invention a pour objet un panneau solaire selon la revendication 1.

Les panneaux solaires sont de ce fait flottants de manière autonome les uns par rapport aux autres. Leur structure flottante est ainsi dénommée car elle soutient et porte les moyens de captation (elle est en ce sens « structurelle »). La conception compacte des panneaux selon l'invention les rend robustes et facilement transportables. La répartition des moyens de flottaison sous la face supérieure permet un excellent maintien et une stabilité maximale du panneau à flot. En outre, ils peuvent supporter le poids d'un ou deux hommes en prévision d'opérations de maintenance. La face supérieure est affleurante donc constamment mouillée sous l'influence de la houle. Les oiseaux n'aimant pas avoir les pattes mouillées ne se poseront pas ou très peu sur la face supérieure du panneau, prévenant ainsi les déjections d'oiseaux et assurant une bonne longévité au panneau ainsi qu'un entretien minimal. Les frais d'entretien et de maintenance sont considérablement réduits ce qui optimise les conditions économiques d'exploitation de tels panneaux.

Selon d'autres caractéristiques avantageuses de l'invention, les moyens de captation de l'énergie solaire sont constitués de cellules photovoltaïques.

Le panneau offre une prise au vent minimale et est moins sujet aux basculements ou déséquilibres résultant d'une forte houle. La stabilité du panneau à la surface de l'eau est grandement améliorée.

Selon encore d'autres caractéristiques avantageuses de l'invention, le panneau solaire a, vu du dessus, la forme générale d'un parallélogramme, par exemple un rectangle ou un carré. Sa surface est de préférence inférieure à 4 m², par exemple entre 1 et 2 m². Le panneau a typiquement, mais de manière non exclusive des dimensions de l'ordre de 1m50 - 1m60 par 0m90-1m. Un tel panneau est très compact de par ses dimensions extérieures. Ses dimensions s'apparentent aux dimensions classiques d'un panneau utilisé sur terre, au sol ou monté sur un toit. Un tel panneau est facilement transportable, permet une installation aisée. En outre, en cas de dysfonctionnement, il peut être remplacé de façon autonome et isolée, sans toucher aux autres panneaux alentour qui fonctionnement correctement. Selon encore d'autres caractéristiques avantageuses de l'invention, les moyens de flottaison sont uniformément répartis sous la face supérieure. Selon encore d'autres caractéristiques avantageuses de l'invention, les moyens de flottaison sont répartis à la périphérie de la face supérieure.

Selon encore d'autres caractéristiques avantageuses de l'invention, la structure flottante comprend un châssis dans lequel sont empilés, du bas vers le haut, au moins une plaque support, notamment en fibre de verre, au moins une plaque flottante, notamment en polymère, et une couche de moyens de captation de l'énergie solaire.

Selon encore d'autres caractéristiques avantageuses de l'invention, le châssis comprend un cadre dont les côtés en fibre de verre sont jointifs aux angles du cadre via des équerres, en particulier métalliques inoxydables.

Selon encore d'autres caractéristiques avantageuses de l'invention, le châssis comprend une armature métallique inoxydable ayant la forme générale d'un cadre.

Selon encore d'autres caractéristiques avantageuses de l'invention, le panneau solaire comprend des absorbeurs de chocs situés à la périphérie du panneau, ces absorbeurs étant notamment flottants et réalisés en polyuréthane.
Selon encore d'autres caractéristiques avantageuses de l'invention, le panneau solaire comprend des moyens d'accrochage permettant d'arrimer entre eux plusieurs panneaux solaires du même type.
Selon encore d'autres caractéristiques avantageuses de l'invention, le panneau solaire comprend au moins un connecteur électrique étanche permettant le raccordement électrique des cellules photovoltaïques. Ce connecteur est accessible et offre une grande sûreté d'utilisation.

L'invention a également pour objet une installation solaire comprenant un assemblage de plusieurs panneaux solaires ayant tout ou partie des caractéristiques précédentes, les panneaux individuellement à flot étant juxtaposés les uns aux autres en formant un maillage, ayant notamment la forme générale d'un carré ou d'un rectangle. D'autres formes sont bien entendu envisageables, par exemple des formes circulaires ou polygonales. Bien qu'assemblés les uns aux autres, chaque panneau flotte sur l'eau de façon autonome. L'installation offre une grande facilité de pose et d'entretien. La situation globalement affleurante des panneaux à la surface de l'eau induit un faible impact visuel sur l'environnement marin et côtier. Les panneaux autonomes sont déplaçables les uns par rapport aux autres (par déformation des câbles, cordes, sangles ou tiges rigides qui les relient) : les panneaux peuvent prendre des inclinaisons plus ou moins prononcées les uns par rapport aux autres de façon à être parfaitement adaptés aux phénomènes de houle. Les coûts sont optimisés et offre une alternative sérieuse à des installations terrestres classiques mais également aux installations marines plus complexes ou rigides que l'on connaît.
Selon d'autres caractéristiques avantageuses de l'invention, les panneaux de l'installation sont arrimés directement les uns aux autres, via un système de cordes, de câbles ou de sangles reliant leur châssis ou leur plaque support ou leurs absorbeurs de chocs.
Selon encore d'autres caractéristiques avantageuses de l'invention, les panneaux sont arrimés sur un maillage commun de câbles, de cordes ou de sangles, via leur châssis ou plaque support ou leurs absorbeurs de chocs. Selon encore d'autres caractéristiques avantageuses de l'invention, l'installation comprend des moyens de retenue périphérique situés autour de l'ensemble de panneaux solaires de façon à l'immobiliser avec un agencement sensiblement plat des panneaux juxtaposés les uns aux autres. Selon encore d'autres caractéristiques avantageuses de l'invention, les moyens de retenue périphérique sont constitués de plusieurs bouées de flottaison immobilisées par un système de masses immergées, notamment quatre bouées de flottaison situées aux quatre coins d'un ensemble de panneaux solaires ayant une forme générale en carré ou en rectangle. Selon encore d'autres caractéristiques avantageuses de l'invention, au moins un moyen de retenue périphérique incorpore dans un mode de réalisation particulier un convertisseur statique pour le traitement de l'électricité provenant des panneaux solaires de type photovoltaïque par des moyens de conduction adaptés, ce convertisseur acheminant l'électricité à un réseau électrique distant de l'installation solaire.

L'invention sera mieux comprise à la lecture de la description qui va suivre d'un mode de réalisation non limitatif de l'invention et à la lumière des dessins annexés sur lesquels :
- la figure 1 représente un panneau solaire selon un premier mode de réalisation de l'invention,
- la figure 2 représente une vue en perspective éclatée du panneau solaire de la figure 1,
- la figure 3 est une vue en perspective d'un détail de réalisation du panneau de la figure 1 illustrant la position d'un connecteur électrique étanche,
- la figure 4 est une vue en perspective d'un panneau solaire selon un autre mode de réalisation de l'invention,
- la figure 5 illustre un détail de réalisation du panneau de la figure 4, représentant des moyens d'accrochage du panneau,
- la figure 6 représente un panneau solaire selon encore un autre mode de réalisation de l'invention,
- la figure 7 est une vue en perspective éclatée du panneau solaire de la figure 6,
- la figure 8 représente un panneau solaire selon encore un autre mode de réalisation de l'invention, dans le quel sont prévus des moyens de concentration, contribuant en particulier à la tenue structurelle et à la rigidité du panneau,
- la figure 9 représente une vue en perspective éclatée du panneau solaire de la figure 8,
- la figure 10 représente encore un autre mode de réalisation du panneau solaire selon l'invention,
- les figures 11 et 12 illustrent deux variantes de réalisation du panneau solaire de la figure 10, dans lesquelles une structure gonflable est porteuse ou non,
- les figures 13 et 14 représentent deux vues en perspectives, de dessus et de dessous, d'un panneau solaire selon un autre mode de réalisation de l'invention, dans lequel les moyens de flottaison sont constitués d'un boudin gonflable périphérique,
- la figure 15 représente encore un autre mode de réalisation de l'invention dans lequel les moyens de flottaison sont constitués dans cet exemple de deux couches de bambous superposées,
- la figure 16 représente en vue du dessus, un exemple d'installation de panneaux solaires selon l'invention,
- la figure 17 illustre une vue agrandie d'un détail de l'assemblage de panneaux solaires suivant l'invention, dans lequel les panneaux sont directement reliés les uns aux autres,
- la figure 18 illustre un moyen de retenue situé en périphérie de l'installation de panneaux solaire suivant l'invention, ce moyen étant typiquement une bouée de flottaison,
- la figure 19 est une vue agrandie de la bouée de la figure 18, illustrant les moyens de liaison mécaniques et les moyens de conduction électrique arrivant à la bouée, dans laquelle est incorporée un convertisseur statique,
- la figure 20 est une vue agrandis de l'assemblage de panneaux solaire suivant l'invention, dans lequel les panneaux sont arrimés à un maillage de câbles, de cordes ou de sangles,
- les figures 21 et 22 sont des vues agrandies des moyens de liaison mécanique de l'assemblage de la figure 20 et des moyens de conduction électrique reliant les panneaux à la bouée renfermant un convertisseur statique, et
- la figure 23 est une vue en perspective d'un moyen de retenue périphérique de l'installation, typiquement une bouée de retenue, montrant un système de masses immergées auxquelles est relié le moyen de retenue. Sur ces figures, les traits mixtes fins représentent des limites fictives de représentation, les éléments se prolongeant en réalité au-delà de ces traits.

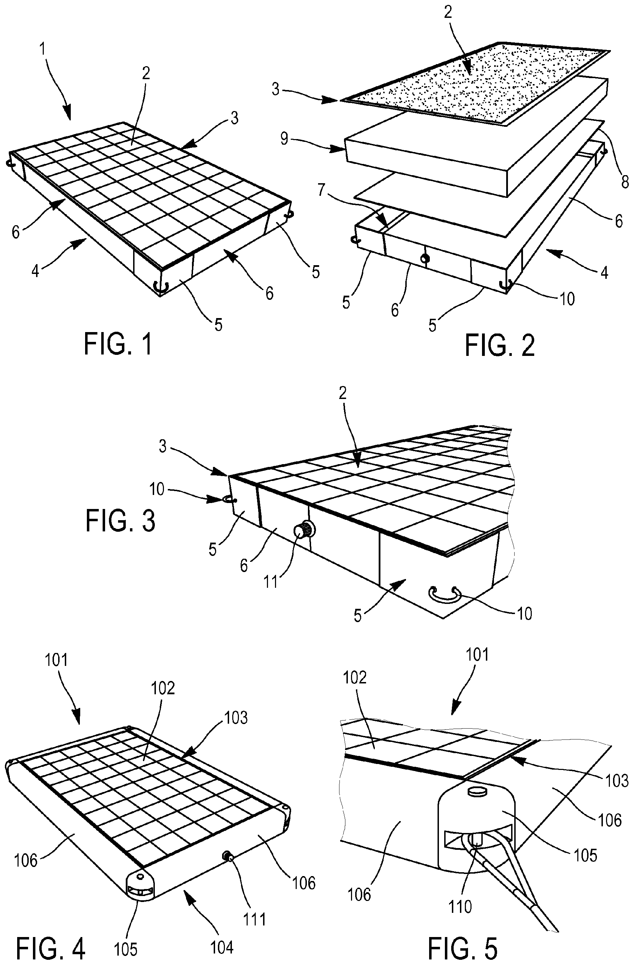

On a représenté à la figure 1 un panneau solaire 1 selon l'invention. Le panneau illustré est typiquement un panneau solaire à cellules photovoltaïques 2 disposées sur une face supérieure du panneau 1. La face supérieure désigne plus précisément une face du panneau qui est tournée vers le haut et est exposée aux rayons solaires. Dans l'exemple illustré, cette face supérieure comporte 60 cellules solaires de tailles standard 156 mm X 156 mm, ce qui lui confère des dimensions de l'ordre de 0,93 m X 1,56 m. Le panneau solaire de cet exemple a une surface de l'ordre de 1,45 m², sachant que des panneaux ayant d'autres dimensions et un nombre de cellules différent sont également inclus dans le cadre de l'invention. On conçoit plus généralement qu'un tel panneau ait une surface inférieure à 4 m², en particulier une surface de cellules comprise entre 1 et 2 m², le critère étant qu'un tel panneau ait des dimensions classiques et une compacité permettant un transport et une installation aisée par une ou deux personnes. De façon traditionnelle un panneau solaire à cellules photovoltaïques a une puissance comprise entre 0,1 et 0,15 kW/m², par exemple de 0,13 kW/m². Un panneau ayant les dimensions de l'exemple précédent de 1,45 m² offre donc une puissance d'environ 0,19 kW.

Pour protéger les cellules photovoltaïques 2, celles-ci sont typiquement réunies dans un module solaire 3 constitué d'une couche supérieure de protection en verre trempé parfaitement transparent et pouvant être traité pour lutter contre les mousses. Le verre peut en outre être éventuellement polarisant comme cela est connu de l'homme du l'art des modules solaires photovoltaïques. Le module est également constitué d'une couche inférieure recouverte d'un film spécial. Les cellules photovoltaïques 2 sont insérées par encapsulation entre ces deux couches dans une masse étanche transparente et résistante aux UV. Le module solaire est très résistant aux sollicitations mécaniques et aux impacts. Dans le cadre de l'invention, le module solaire que l'on désigne plus simplement et plus généralement par « cellules photovoltaïques » est monté de façon étanche sur une structure porteuse flottante monobloc. Les cellules photovoltaïques sont disposées sur une face supérieure du panneau solaire 1 exposée aux rayons du soleil.

La structure flottante est dite « monobloc » en ce sens qu'elle est constituée d'éléments assemblés rigidement les uns aux autres, de façon compacte, c'est-à-dire sans élément ou partie en saillie par rapport à la forme générale du panneau. Le panneau a comme son nom l'indique une forme générale aplatie qui en vue de dessus est celle d'un quadrilatère, typiquement un rectangle ayant les dimensions précitées.

Le panneau 1 selon l'invention a de façon remarquable une épaisseur sensiblement constante dans au moins une région périphérique.

En référence à l'exemple de réalisation de la figure 2, le panneau 1 comprend un châssis 4 ayant la forme générale d'un cadre rectangulaire. Les côtés du châssis 4 sont disposés à la périphérie du panneau 1. La hauteur du châssis 4 détermine sensiblement la hauteur du panneau. Le châssis 4 comprend quatre angles 5 ou équerres métalliques. Ces angles 5 sont reliés deux à deux par des profilés 6 typiquement en fibre de verre, pour former les petits et grands côtés du cadre. Les profilés ont un rebord inférieur 7 tourné vers le centre du panneau 1, ce rebord constituant une surface de retenue des éléments insérés dans le châssis 4. En allant du bas vers le haut à la figure 2, sont empilés à l'intérieur du châssis 4 :
- une plaque support 8 formant un fond rigide du panneau 1, par exemple en fibre de verre,
- des moyens de flottation 9 constitués dans cet exemple d'une plaque flottante par exemple en polymère, dont la fonction est d'une part d'assurer la flottaison du panneau à la surface de l'eau, mais également de constituer un élément structurel apportant une grande rigidité au panneau (s'opposant notamment à la flexion et à la torsion ou au gauchissement du panneau).
- une couche de cellules photovoltaïques 2 sous la forme d'un module solaire 3 comme expliqué précédemment.

Dans cet exemple, le panneau est disposé à plat, de façon sensiblement horizontale (position théorique à la surface d'une eau calme, en l'absence de houle).

Selon un aspect particulièrement intéressant de l'invention, les moyens de flottaison 9 sont inclus dans l'épaisseur du panneau, considérée suivant une direction perpendiculaire à la face supérieure du panneau. Dans l'exemple des figures 1 et 2, ces moyens de flottaison représentent même pratiquement l'épaisseur du panneau 1, ou tout au moins plus de 75% de celle-ci. Les moyens de flottaison sont en outre dans cet exemple uniformément répartis sous la forme d'une plaque en dessous de la face supérieure du panneau 1. Comme cela sera indiqué ultérieurement, on note qu'une répartition au moins périphérique des moyens de flottaison dans une région périphérique assure une stabilité appropriée à la surface de l'eau.

La structure flottante est adaptée pour disposer la face supérieure du panneau 1 de façon sensiblement affleurante avec le niveau de l'eau (position théorique en eau calme). A cet effet, les propriétés de flottabilité des moyens de flottaison 9 doivent être adaptées au poids global du panneau solaire 1, de manière à compenser la gravité du panneau 1 par la poussée d'Archimède et disposer ainsi sa face supérieure au niveau requis. Ceci est particulièrement vrai dans ce premier mode de réalisation. On verra ultérieurement que le panneau 1 peut être maintenu à flot par d'autres moyens ou avec l'assistance d'autres moyens, auquel cas ce critère pourra être moins déterminant.
Dans une variante de réalisation non illustrée des moyens de flottaison, ceux-ci peuvent être constitués d'une structure alvéolaire, par exemple en nids d'abeille.
Le panneau solaire des figures 1 à 3 comporte en outre des moyens d'accrochage 10, constitués en l'espèce d'un anneau métallique inoxydable solidaire de chacun des angles 5. Ces moyens d'accrochage 10 permettent d'arrimer entre eux plusieurs panneaux 1 du même type ou de les amarrer à un point fixe via un système de câbles, ou de cordes ou de sangles ou même de tiges rigides / biellettes.

Le panneau solaire de l'invention comprend en outre un connecteur électrique étanche 11 permettant le raccordement électrique du panneau à un convertisseur statique externe au panneau comme expliqué ci-après. Un tel connecteur étanche est par exemple de niveau de protection IP68 selon une classification internationale. Dans l'exemple illustré, le connecteur étanche 11 débouche sur un petit côté du châssis 4, typiquement au centre, dans l'épaisseur de la tranche du panneau 1. Dans une variante, le connecteur peut également déboucher sur un grand côté du panneau. Il peut également dans une autre variante encore être intégré au mécanisme de solidarisation du panneau.

D'autres modes de réalisation sont décrits ci-après uniquement en ce qu'ils diffèrent du mode de réalisation précédent. Des moyens similaires dans leur structure ou dans leur fonction à ceux qui ont été décrits précédemment ont des références numériques identiques ou augmentées de cent par rapport à l'exposé précédent.

On a représenté à la figure 4 un autre mode de réalisation d'un panneau 101 selon l'invention, dans lequel la structure flottante comprend un châssis 104 ayant la forme générale d'un cadre rectangulaire en vue de dessus. Ce châssis 104 est constitué de quatre angles 105 en quart de cercle ou de cylindre reliés deux à deux par des profilés 106 ayant une section transversale en forme de U, l'ouverture du U étant tournée vers le centre du panneau 101 tandis que la partie centrale joignant les deux branches du U est tournée vers l'extérieur du panneau 101. De préférence, la partie centrale du U tournée vers l'extérieur a une forme arrondie ou au moins des angles arrondis présentant un aspect non agressif, à l'image des angles 105 arrondis en quart de cercle ou de cylindre.
Le châssis 104 de la figure 4 comporte un rebord intérieur (non représenté) ou une surface s'appui périphérique de retenue des éléments empilés semblables à ceux décrits précédemment (plaque support, moyens de flottaison ayant la forme d'une plaque flottante, module solaire 103). Le châssis constitue un élément de structure se substituant dans ce cas au châssis 4 du panneau des figures 1 à 3.
Le châssis 104 constitue en outre un absorbeur de chocs périphérique permettant d'adoucir le contact entre des panneaux ou avec n'importe quel corps étranger. Il préserve ainsi le module 103 de cellules photovoltaïques d'éventuelles dégradations. On note que l'absorbeur de chocs périphérique peut être conformé sur toute l'étendue de la périphérie du panneau. Dans une variante de réalisation, l'absorbeur de choc peut localisé dans certaines zones périphériques uniquement, par exemple aux angles extérieurs du panneau.
De façon optionnelle, un tel châssis 104 peut assurer en plus une fonction de flottaison, susceptible d'être utilisée en lieu et place, ou en complément, des moyens de flottaison situés en dessous de la face supérieure du panneau 101. A cet effet, le châssis 104 peut être constitué de profilés 106 fermés hermétiquement (du côté de l'ouverture du U) ou comblés d'une matière flottante (non représentée). L'ensemble de la structure flottante est comme précédemment adapté à une flottaison affleurante de la face supérieure du panneau avec le niveau de l'eau (position théorique, en eau calme).
Le panneau 101 est ici également équipé d'un connecteur étanche 111 de niveau IP68 débouchant à l'extérieur du châssis 104.
Des moyens d'accrochage 110, constitués en l'espèce d'axes insérés dans chacun des angles 105 du panneau 101 permettent d'arrimer entre eux plusieurs panneaux 101 du même type ou de les amarrer à un point fixe via un système similaire à celui évoqué précédemment (câbles, cordes, sangles, tiges rigides / biellettes).

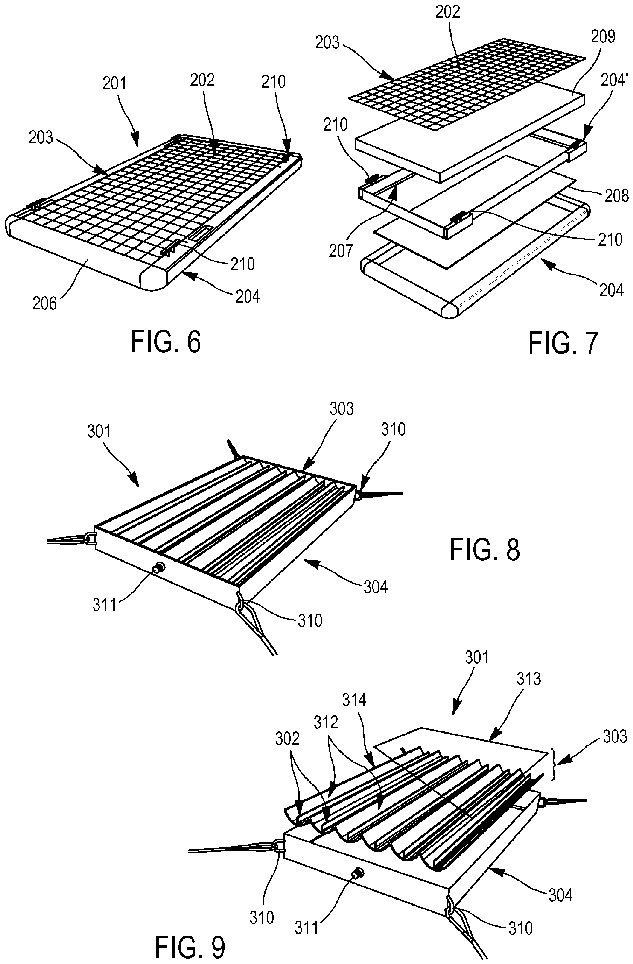

Selon un autre mode de réalisation illustré aux figures 6 et 7, la structure flottante du panneau 201 comprend un châssis 204 ayant une forme extérieure semblable au châssis 104 de la figure 4, et est renforcée par un cadre intérieur 204' analogue au cadre 6 des figures 1 à 3. La tenue mécanique est assurée tant par le cadre intérieur 204' que par le châssis 204. Des éléments empilés sont insérés dans la structure flottante (figure 7), du bas vers le haut : une plaque support 208, des moyens de flottaison 209 contribuant également à la rigidité du panneau, un module 3 de cellules photovoltaïques. La retenue des éléments empilés est réalisée par un rebord inférieur ou une surface d'appui 207 prévue à la base du cadre intérieur 204' ou à la base du châssis 204, ce rebord étant dans ce cas en saillie vers l'intérieur du panneau 201 en dessous du cadre intérieur 204' (non illustré).
Le châssis 204 comporte un absorbeur de chocs périphérique analogue à celui 104 des figures 4 et 5, s'étendant sur toute la périphérie du panneau ou situé dans des zones localisées uniquement.
Le panneau 201 est également équipé d'un connecteur étanche (non représenté) de niveau IP68 débouchant à l'extérieur du châssis 204.
Le panneau 201 est ici également équipé d'un connecteur étanche (non représenté) de niveau IP68 débouchant à l'extérieur du châssis 204.
Le panneau 201 comprend également des moyens d'accrochage 210, qui peuvent être semblables à ceux déjà présentés, ou en variante comme illustré aux figures 6 et 7, d'éléments en saillie par rapport à la face supérieure du panneau 201. Dans cet exemple, chaque élément a la forme d'un barreau horizontal relié à la face supérieure du châssis et maintenu à distance de celle-ci via un ou deux axes verticaux. Ces éléments en saillie sont au nombre de quatre, sensiblement situés aux quatre angles du châssis 204. Ils permettent d'arrimer entre eux plusieurs panneaux 201 du même type ou de les amarrer à un point fixe via un système de câbles ou de cordes.

Un autre mode de réalisation est encore illustré aux figures 8 et 9. Ce panneau 301 comprend une structure flottante analogue au panneau des figures 1 à 3. Contrairement au cas précédent, le module solaire 303 est ici pourvu d'un concentrateur ou est agencé de façon à optimiser le rendement des cellules photovoltaïques 302. Dans un exemple non exhaustif d'agencement des cellules photovoltaïques à l'intérieur d'un module solaire, les cellules 302 peuvent être recouvertes de moyens polarisants (non représentés) ou être agencées par exemple de façon non horizontale (par exemple verticale). Dans ce dernier cas, des moyens de réflexion 312 des rayons solaires, constitués de surfaces de réflexion concaves, sont ménagés dans le module solaire 303. Ces surfaces concaves peuvent être par exemple de forme demi-cylindrique, juxtaposées les une aux autres selon une forme générale plane. Les parties concaves recevant les cellules 302 sont tournées vers le haut. Une paroi transparente 313 recouvre les moyens de réflexion 312. Des plaques d'extrémité ferment également les extrémités des demi-cylindres de façon à former avec les moyens de réflexion 312 un boitier fermé hermétiquement et étanche à l'eau. Les plaques d'extrémité sont par exemple formées des petits côtés ou des grands côtés du châssis 304 en forme de cadre (petits côtés dans l'exemple illustré).
On peut prévoir que le panneau 301 soit constitué des éléments empilés suivants : plaque support, moyens de flottaison, module solaire (du bas vers le haut). En variante, on peut prévoir que le module solaire 303 assure en soi la flottaison du panneau en raison du volume d'air qu'il renferme de façon étanche. Dans ce dernier cas, la plaque support et/ou les moyens de flottaison peuvent être supprimés. L'élément 314 dans lequel sont formés les moyens de réflexion 312 est dans ce cas structurel et contribue à la rigidité de la structure flottante lorsqu'il est associé au châssis 304 en forme de cadre. Les formes creuses et en saillie agissent de façon analogue à des nervures de rigidification et s'opposent notamment à la flexion et à la torsion du panneau.
Le panneau 301 est ici également équipé d'un connecteur étanche 311 de niveau IP68 débouchant à l'extérieur du châssis 304.
Des moyens d'accrochage 310, constitués d'anneaux reliés à chacun des angles du panneau 301 permettent d'arrimer entre eux plusieurs panneaux 301 du même type ou de les amarrer à un point fixe via un système similaire à celui évoqué précédemment (câbles, cordes, sangles, tiges rigides / biellettes).
La structure flottante constituée est adaptée à une flottaison du panneau telle que la face supérieure du panneau 301 est affleurante avec le niveau de l'eau (position théorique, en eau calme).

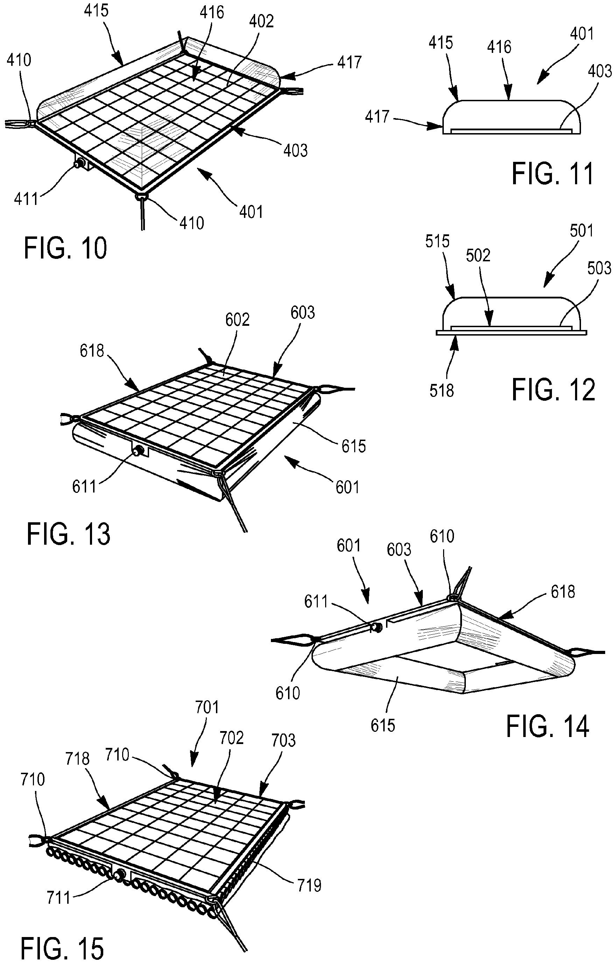

On a représenté aux figures 10 et 11 un autre mode de réalisation du panneau solaire 401 selon l'invention, dans lequel le module solaire 403 est intégré à une structure flottante disposée par-dessus les cellules photovoltaïques 402 ou recouvrant celle-ci intégralement. La structure flottante comprend une enveloppe pneumatique 415 souple ou rigide fermée sur elle-même de façon étanche. Celle-ci est par exemple en polymère. L'enveloppe a une forme générale rectangulaire en vue de dessus, dont les bords périphériques coïncident sensiblement avec ceux du module solaire 403 comprenant les cellules photovoltaïques 402. L'enveloppe 415 comporte une paroi supérieure 416 transparente ou translucide ou tout au moins perméable aux rayons solaires. Les parois latérales 417 peuvent également être perméables aux rayons solaires. L'enveloppe a une partie supérieure ayant au centre une forme légèrement bombée ou sensiblement plane, les parties périphériques étant également arrondies autour des bords périphériques du module solaire 403. La structure flottante est structurelle dans ce cas et assure la rigidité de l'ensemble. Les moyens de captation de l'énergie solaire, en l'occurrence les cellules photovoltaïques, sont situés à l'intérieur et à la base de l'enveloppe 415. Comme illustré dans cet exemple, la face supérieure sur laquelle sont disposées les cellules photovoltaïques n'est pas nécessairement une face située en haut du panneau, mais une face tournée vers le haut.

On a illustré à la figure 12 un autre mode de réalisation d'un panneau 501 selon l'invention. Ce dernier comprend une structure flottante constituée d'une enveloppe pneumatique 515 comme dans le cas précédent. La structure comprend en outre une plaque support 518 sur laquelle est disposé le module solaire 503, les cellules étant situées sur une face supérieure, c'est-à-dire tournée vers le haut. L'enveloppe peut être refermée sur elle-même de façon étanche, ou peut être reliée de façon étanche à une zone périphérique de la plaque support 518, autour du module solaire 503. La plaque support 518 contribue à la rigidité de l'ensemble (anti-flexion, anti flexion ou gauchissement).

Le panneau 411 est également équipé d'un connecteur étanche 411 de niveau IP68 débouchant à l'extérieur de la structure porteuse, par exemple en dessous du module solaire 403 ou de la plaque support 518.

Dans les exemples des figures 10 à 12, des moyens d'accrochage 410 par exemple constitués d'anneaux d'arrimage peuvent être prévus aux quatre angles du panneau 401 pour relier entre eux plusieurs panneaux de même type ou les relier à un point fixe, par l'intermédiaire d'un système similaire à celui évoqué précédemment (câbles, cordes, sangles, tiges rigides / biellettes).

La structure flottante constituée est adaptée à une flottaison du panneau telle que la paroi supérieure 416, 516 de l'enveloppe 415, 515 est affleurante avec le niveau de l'eau (position théorique, en eau calme).

Les figures 13 et 14 représentent encore un autre mode de réalisation d'un panneau 601 suivant l'invention. Le panneau comprend une structure flottante constituée d'un boudin (ou flotteur) pneumatique 615 ayant la forme générale d'un cadre rectangulaire. Ses branches ont par exemple une section transversale sensiblement circulaire. Le boudin 615 est situé en périphérie du panneau 601. Le module solaire 603 intégrant les cellules 602 est monté sur une plaque support 618 de forme générale rectangulaire correspondant sensiblement à la forme du module solaire. La plaque support 618 est montée et fixée à sa périphérie sur une zone supérieure du boudin pneumatique 615.
La structure flottante constituée de la plaque support 618 et du boudin pneumatique 615 accolés l'un à l'autre est rigide et résistante aux phénomènes de flexion, de torsion ou de gauchissement.
Le panneau 601 est équipé d'un connecteur étanche 611 de niveau IP68 débouchant à l'extérieur de la structure flottante, par exemple en dessous de la plaque support 618.
Des moyens d'accrochage 610 constitués d'anneaux d'arrimage sont prévus aux quatre angles du panneau 601 pour relier entre eux plusieurs panneaux de même type ou les relier à un point fixe, par l'intermédiaire d'un système similaire à celui évoqué précédemment (câbles, cordes, sangles, tiges rigides / biellettes).
La structure flottante est adaptée à une flottaison du panneau 601 de sorte que la face supérieure soit affleurante avec le niveau de l'eau (position théorique, en eau calme).

La figure 15 représente encore un autre mode de réalisation du panneau 701 suivant l'invention, dans lequel la structure flottante est constituée d'un module solaire 703 à cellules photovoltaïques 702 et d'une plaque support 718 de même type que ceux des figures 13 et 14.
Le module solaire 703 est ici monté sur des moyens de flottaison 715 « naturels » de type bambous ou rondins de bois ou autres éléments équivalents à faible impact environnemental, tels que des bouteilles en plastique recyclées. Dans l'exemple illustré à la figure 15, la structure est constituée de deux couches superposées de tiges de bambous ou de rondins juxtaposés parallèlement les uns aux autres dans chaque couche, les bambous des deux couches adjacentes étant perpendiculaires les uns aux autres. On comprend que l'invention s'étend à toute configuration comprenant au moins deux couches de tiges de bambou ou de rondin. Un arrangement de trois couches ou même davantage est parfaitement envisageable.
Comme dans les modes de réalisations précédemment décrits, le panneau 701 est équipé d'un connecteur étanche 711 de niveau IP68 débouchant en périphérie de la structure flottante, par exemple en dessous de la plaque support 718.
Des moyens d'accrochage 710 constitués d'anneaux d'arrimage sont prévus aux quatre angles du panneau 701 pour relier entre eux plusieurs panneaux de même type ou les relier à un point fixe, par l'intermédiaire d'un système similaire à celui évoqué précédemment (câbles, cordes, sangles, tiges rigides / biellettes).
La structure flottante est adaptée à une flottaison du panneau 701 de sorte que la face supérieure soit affleurante avec le niveau de l'eau (position théorique, en eau calme).

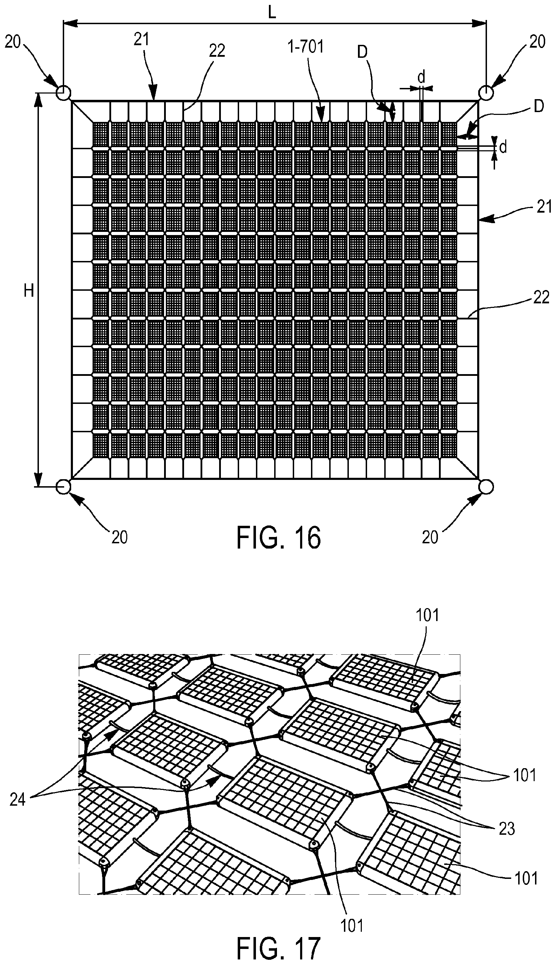

Chaque panneau 1-701 de l'invention décrit précédemment constitue un composant élémentaire d'une installation plus vaste faisant également l'objet de la présente invention. Cette installation constitue un « champ » ou « ensemble » de panneaux solaires 1-701 tels que précédemment décrits, qui sont individuellement installés à flot, les panneaux étant juxtaposés et arrimés les uns aux autres par des systèmes à câbles ou cordes pour former un maillage. Ce maillage peut avoir une forme générale rectangulaire ou carrée en vue de dessus, comme illustré à la figure 16. Sans sortir du cadre de l'invention, le maillage peut avoir d'autres forme géométrique en vue de dessus, par exemple circulaire, hexagonale ou autre.
A la figure 16 on a représenté en vue de dessus un exemple d'une telle installation comprenant un maillage s'apparentant à une matrice : en effet dans cet exemple les panneaux solaires 1-701 sont alignés les uns avec les autres suivant des lignes et des colonnes.
L'exemple représente 240 panneaux solaires 1-701 alignés suivant 20 colonnes de 12 panneaux chacune. On considère dans cet exemple que les panneaux 1-701 rectangulaires ont des dimensions de 1,56 m X 0,93 m, et qu'un écart d de l'ordre de 0,30 m est ménagé entre chaque panneau (dans le cas présent, entre deux lignes adjacentes et entre deux colonnes adjacentes). D'autres dimensions de panneaux peuvent être envisagées. La liaison et cet écart entre les panneaux sont assurés par un système de cordes ou câbles. On note qu'un tel écart entre les panneaux assure avantageusement un passage de la lumière entre les panneaux ce qui permet de maintenir de bonnes conditions de photosynthèse des fonds marins et ne perturbe pas l'environnement animal et/ou végétal. Dans certaines situations, il convient en effet d'éviter que l'installation forme un écran de grandes dimensions qui soit nuisible à l'environnement.
Le maillage de panneaux 1-701 est maintenu en périphérie et/ou soumis à une traction périphérique dirigée vers l'extérieur, sous l'influence de moyens de retenue périphériques 20, 21. Ceux-ci comprennent des bouées 20 situées autour du maillage de panneaux 1-701. Dans l'exemple décrit, quatre bouées 20 situées aux quatre coins d'un rectangle ou d'un carré sont reliées entre elles deux à deux par quatre tringles 21 constituées de câbles ou cordes ou sangles sensiblement tendus. Dans une variante de réalisation, ces tringles peuvent être constituées de tiges rigides qui en outre peuvent contenir la connexion ou des éléments pneumatiques ou des joints de liaison avec les panneaux. Les tringles 21 matérialisent une forme rectangulaire ou carrée de l'installation. Les bouées sont immobilisées comme on le verra ci-après. La distance D entre chaque panneau situé à l'extérieur du maillage et la tringle adjacente est d'environ 1,5 m (à titre uniquement illustratif et non exhaustif). L'ensemble des panneaux reliés les uns aux autres est rattaché en périphérie aux tringles 21 via des cordes ou câbles ou sangles ou tiges rigides de liaison périphériques 22. Considérant les dimensions précitées, on obtient dans cet exemple, un champ (ou maillage) de panneaux solaires 1-701 ayant des dimensions de l'ordre de 30,31 m par 28 m (L X H), soit quasiment la forme d'un carré.

Selon un mode de réalisation particulier d'une installation selon l'invention, les panneaux 1-107 sont arrimés directement les uns aux autres, via un système de cordes ou câbles ou de sangles 23 reliant leur châssis ou leurs absorbeurs de chocs. La structure de chaque panneau assure en elle-même la reprise d'effort, essentiellement en traction dans le plan général de l'ensemble des panneaux 1-107. La figure 17 représente un exemple de ce type d'installation, le panneau 107 représenté étant d'un type particulier décrit précédemment, étant entendu que d'autres types de panneaux entrant dans le cadre de l'invention peuvent être également utilisés, notamment des panneaux ayant les références 1, 201-701. Dans cet exemple, quatre panneaux 107 disposés en carré sont reliés diagonalement deux à deux par un jeu de deux cordes 23 se croisant en leur centre. Les cordes 23 peuvent être libres ou jointes à leur point de croisement.
En périphérie, les panneaux sont également reliés aux tringles par des cordes ou câble ou sangle de liaison 22.
En outre des câbles conducteurs 24 relient électriquement les panneaux 1-107 à un convertisseur statique extérieur. A cet effet, les panneaux 1-107 peuvent être reliés à un câble extérieur ou à un réseau commun via leur connecteur unique 11-711 ou via deux connecteurs prévus sur chaque panneaux, les panneaux étant dans ce dernier cas pourvus de moyens de conduction électrique intégrés et pouvant ainsi être disposés en série (ce qui limite le cheminement de câbles électriques à l'extérieur des panneaux et assure donc une meilleure protection de ces câbles).

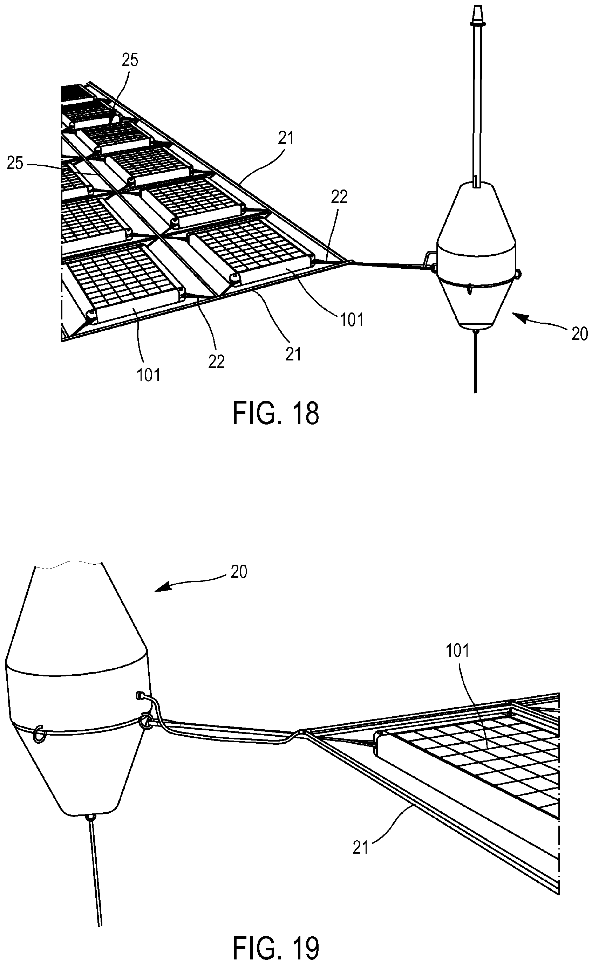

En référence à la figure 18, on a représenté un angle de l'installation de panneaux solaires 101. Comme on peut le voir dans cet exemple, des tringles intérieures 25 peuvent être prévues en compléments des tringles 21 reliant les bouées situées aux angles de l'installation. Ces tringles intérieures sont par exemple situées entre chaque colonne et chaque rangée ou ligne de panneaux solaires 101, de manière à former également un maillage ou une matrice. Les panneaux 101 sont reliés ou arrimés à ce maillage ou à cette matrice commune de câbles ou de cordes ou de sangles via leur structure flottante, notamment leur châssis ou via leurs absorbeurs de chocs. Ces tringles intérieures 25 assurent la tenue mécanique de l'ensemble de l'installation, en supportant tout ou partie des efforts de traction appliqués aux panneaux vers l'extérieur de l'installation (via les moyens de retenue et également sous l'influence de la houle). Les sollicitations mécaniques appliquées sur les panneaux 101 sont ainsi considérablement diminuées, ce qui permet un dimensionnement au juste nécessaire et donc un moindre coût des panneaux.
On note en référence aux figures 18 et 19 que les câbles conducteurs reliés électriquement aux panneaux solaires 101 sont également reliés à un convertisseur statique (non représenté) logé avantageusement dans l'une des bouées 20 de l'installation. La bouée est ainsi équipée d'un système d'ouverture étanche (non représentée) et comprend une enceinte totalement étanche et protégée des agressions extérieures. Dans une variante non représentée de l'invention, le convertisseur statique peut être situé dans une autre enceinte proche de l'installation ou à distance. Une liaison électrique est également assurée entre le convertisseur et une installation ou un réseau électrique distant.

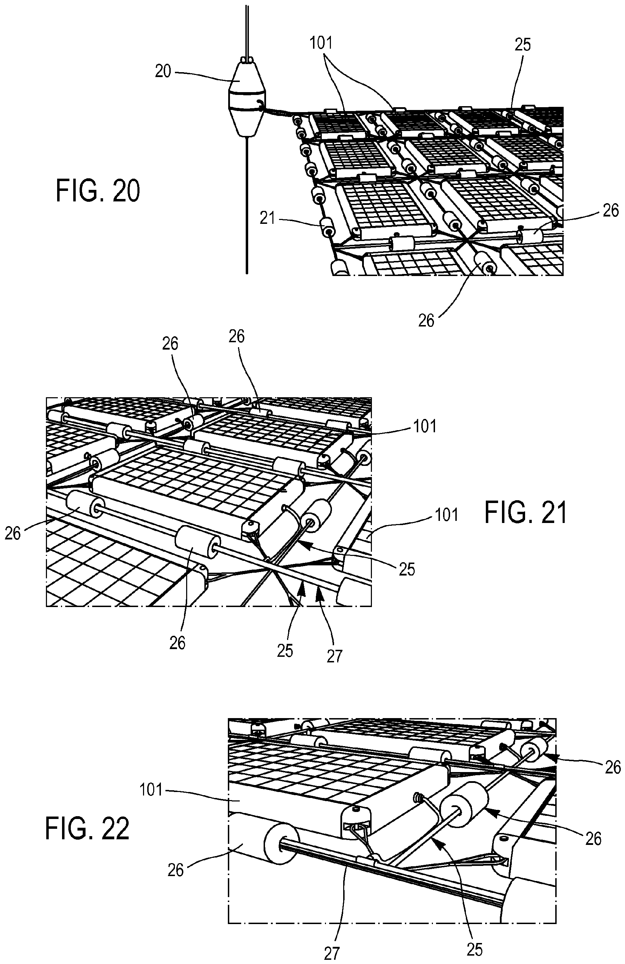

Les figures 20 à 22 représentent en perspective et sous différents angles un autre mode de réalisation de l'installation de panneaux 101 selon l'invention.
Ce mode de réalisation est très proche de celui de la figure 18, à cette différence près que des flotteurs 26 sont prévus sur le maillage ou la matrice de cordes, de câbles ou de sangles (tringles intérieures 25), ainsi que sur les tringles extérieures 21 des moyens de retenue.
Les flotteurs 26 sont répartis sur toute la longueur des tringles 21, 25 et sont distants deux à deux d'environ 0,5 m à 1 m (d'autres agencement sont possibles). Ainsi le maillage (ou matrice) est en lui-même flottant. Les moyens de flottaison intégrés aux panneaux peuvent être maintenus comme expliqués dans les exemples décrits précédemment ou peuvent éventuellement être allégés ou réduits ou même supprimés afin de simplifier la structure des panneaux et de réduire leur coût de fabrication. Dans cet exemple, on a représenté aux figures 21 et 22 que la liaison électrique entre les différents panneaux et le convertisseur statique était assurée par des câbles conducteurs 27 cheminant le long des tringles intérieures 25.

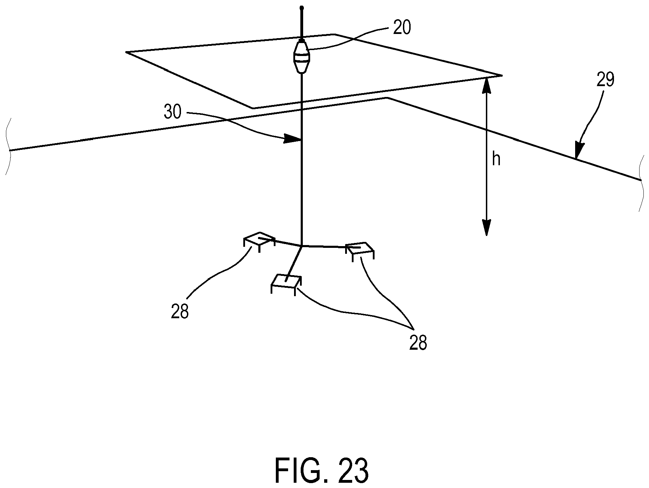

Les bouées 20 sont immobilisées par un système de masses immergées 28 (poids morts) situés environ 15 à 30 m, par exemple 20 m, au dessous de la bouée 20 et reposant au fond 29 de l'eau. L'invention s'applique donc en particulier à des milieux marins ou d'autres milieux aquatiques, ayant une profondeur d'eau d'environ 15-30 m. D'autres modes de réalisation sont également envisageables dans le cadre de l'invention. La liaison entre les bouées 20 et les masses peut être assurée par une chaîne 30, un câble ou tout autre moyen équivalent. Dans l'exemple non exclusif de la figure 23 on prévoit trois masses 28 de 5 tonnes chacune.
En cas d'installation en milieu marin, des moyens de compensation de la hauteur h de l'ensemble des panneaux 1-107 par rapport au fond marin 29 sont prévus pour une adaptation permanente et automatique aux changements de marées (par exemple une longueur suffisante de chaîne reliant chaque bouées 20 aux masses immergées 28).

On a décrit précédemment des panneaux solaires à cellules photovoltaïques. L'invention peut s'appliquer de façon analogue à des panneaux solaires thermiques (échangeur de chaleur / pompe à chaleur, ce mode de réalisation n'étant pas représenté). Un tel panneau selon l'invention comprend des moyens d'échange thermique associés à une structure flottante. Le panneau ainsi constitué peut être amarré à d'autres panneaux de façon analogue à ce qui a été décrit pour des panneaux solaires photovoltaïques. Des conduits peuvent être inclinés pour assurer le fonctionnement adéquat du dispositif. Des canalisations relient les panneaux à un dispositif extérieur utilisant ou traitant de l'eau réchauffée par les panneaux solaires.
L'installation peut en variante être constituée d'un mix de panneaux solaires photovoltaïques et de panneaux solaires thermiques.

En situation de déplacement de l'installation solaire à la surface de l'eau, les tringles peuvent être pourvues, éventuellement de façon provisoire et amovible, de moyens rigides en traction / compression, par exemple des tiges ou entretoises rigides (reliant les bouées), assurant que l'installation conserve sa forme générale et que les panneaux ne s'entrechoquent pas en libérant l'ancrage des bouées.

Dans une variante de réalisation de l'invention, des bouées rigides ayant des formes longitudinales peuvent être prévues et installées sur les côtés du polygone, par exemple sur les quatre côtés du rectangle formé par l'installation de panneaux solaires. Ces bouées rigides sont reliées deux à deux à leurs extrémités et maintiennent la forme générale de la partie périphérique de l'installation. Elles facilitent également les opérations de déplacement de l'installation.
On a également indiqué que chaque panneau solaire selon l'invention avait une épaisseur sensiblement constante suivant une direction perpendiculaire à la face supérieure du panneau. Cette configuration peut être permanente en raison d'un panneau non modifiable ou transformable. En revanche, dans une variante de réalisation non illustrée de l'invention, le panneau solaire selon l'invention peut être transformable entre une première configuration dans laquelle le panneau a effectivement une épaisseur sensiblement constante suivant une direction perpendiculaire à la face supérieure du panneau, et une seconde configuration dans laquelle l'épaisseur est non constante, la face supérieure du panneau étant dans ce dernier cas inclinée par rapport à l'horizontale, par exemple pour une exposition accrue à la lumière ou aux raisons solaires.

Bien entendu, l'invention n'est pas limitée aux moyens qui viennent d'être décrits et comprend tous les équivalents techniques.

## Revendications

1. Panneau solaire (1-107) comprenant des moyens de captation (2-702) de l'énergie solaire, tels que des capteurs solaires ou des cellules photovoltaïques, le panneau comprenant également une face supérieure, dans lequel le panneau comprend une structure flottante monobloc sur laquelle sont montés les moyens de captation (2-702) de l'énergie solaire, ceux-ci étant intégrés à un module solaire (3-703) disposé sur la structure flottante, notamment à plat, le panneau (1-107) ayant dans une direction perpendiculaire à la face supérieure, une épaisseur sensiblement constante dans au moins une région périphérique du panneau (1-107), **caractérisé en ce que** la structure flottante est adaptée pour disposer la face supérieure de façon affleurante avec le niveau d'eau ambiant, lorsque l'eau est calme.

2. Panneau solaire selon la revendication 1, **caractérisé en ce que** les moyens de captation (2-702) de l'énergie solaire sont constitués de cellules photovoltaïques.

3. Panneau solaire selon la revendication 2, **caractérisé en ce qu'**il comprend au moins un connecteur électrique (11-711) étanche, permettant le raccordement électrique des cellules photovoltaïques.

4. Panneau solaire selon l'une quelconque des revendications 1 à 3, **caractérisé en ce qu'**il a, vu du dessus, la forme générale d'un parallélogramme et une surface inférieure à 4 m², en particulier comprise entre 1 et 2 m².

5. Panneau solaire selon l'une quelconque des revendications 1 à 4, **caractérisé en ce que** les moyens de flottaison (9, 209, 303, 415, 515, 615, 719) sont uniformément répartis sous la face supérieure.

6. Panneau solaire selon l'une quelconque des revendications 1 à 5, **caractérisé en ce que** les moyens de flottaison (9, 106, 209, 303, 415, 515, 615, 719) sont répartis à la périphérie de la face supérieure.

7. Panneau solaire selon l'une quelconque des revendications 1 à 6, **caractérisé en ce que** la structure flottante comprend un châssis (4, 104, 204, 204') dans lequel sont empilés, du bas vers le haut, au moins une plaque support (8, 208), notamment en fibre de verre, au moins une plaque flottante (9, 209), notamment en polymère, et une couche de moyens de captation (2-702) de l'énergie solaire.

8. Panneau solaire selon l'une quelconque des revendications précédentes, **caractérisé en ce qu'**il comprend des absorbeurs de chocs (106, 206) situés à la périphérie du panneau (1, 201), ces absorbeurs étant notamment flottants et réalisés en polyuréthane.

9. Panneau solaire selon l'une quelconque des revendications précédentes, **caractérisé en ce qu'**il comprend des moyens d'accrochage (10-710) permettant d'arrimer entre eux plusieurs panneaux solaires du même type.

10. Installation solaire **caractérisée en ce qu'**elle comprend un assemblage de plusieurs panneaux solaires (1-701) selon l'une quelconque des revendications 1 à 9, les panneaux individuellement à flot étant juxtaposés les uns aux autres en formant un maillage, ayant notamment la forme générale d'un carré ou d'un rectangle.

11. Installation solaire selon la revendication 10, **caractérisée en ce que** les panneaux (1-701) sont arrimés directement les uns aux autres, via un système de cordes, de câbles ou de sangles reliant leur châssis (4, 104, 204, 304) ou plaque support (618, 718), ou leurs absorbeurs de chocs (106, 206).

12. Installation solaire selon la revendication 11, **caractérisée en ce que** les panneaux sont arrimés sur un maillage (21, 25) commun de câbles, de cordes ou de sangles, via leur châssis (4, 104, 204, 304) ou plaque support (618, 718) ou leurs absorbeurs de chocs (106, 206).

13. Installation solaire selon l'une quelconque des revendications 10 à 12, **caractérisée en ce qu'**elle comprend des moyens de retenue périphérique (20) situés autour de l'ensemble de panneaux solaires (1-701) de façon à l'immobiliser avec un agencement sensiblement plat des panneaux (1-701) juxtaposés les uns aux autres.

14. Installation solaire selon la revendication 13, **caractérisée en ce que** les moyens de retenue périphérique (20) sont constitués de plusieurs bouées de flottaison immobilisées par un système de masses immergées (28), notamment quatre bouées de flottaison situées aux quatre coins d'un ensemble de panneaux solaires (1-701) ayant une forme générale en carré ou en rectangle.

15. Installation solaire selon la revendication 13 ou 14, **caractérisée en ce qu'**au moins un moyen de retenue périphérique (20) incorpore un convertisseur statique pour le traitement de l'électricité provenant des panneaux solaires (1-701) de type photovoltaïque par des moyens de conduction adaptés, ce convertisseur acheminant l'électricité à un réseau électrique distant de l'installation solaire.

## Patentansprüche

1. Solarpaneel (1-107), enthaltend Einrichtungen (2-702) zum Aufnehmen von Sonnenenergie, wie etwa Sonnenkollektoren oder Photovoltaikzellen, wobei das Paneel auch eine Oberseite umfasst, wobei das Paneel eine einteilige, schwimmfähige Struktur enthält, an der die Einrichtungen (2-702) zum Aufnehmen von Sonnenenergie angebracht sind, wobei diese in ein Solarmodul (3-703) integriert sind, das an der schwimmfähigen Struktur insbesondere flach liegend angeordnet ist, wobei das Paneel (1-107) in einer Richtung senkrecht zur Oberseite eine im Wesentlichen konstante Dicke in mindestens einem Umfangsbereich des Paneels (1-107) aufweist, **dadurch gekennzeichnet, dass** die schwimmfähige Struktur dazu ausgelegt ist, um die Oberseite bei ruhigem Wasser bündig mit dem Umgebungswasserstand anzuordnen.

2. Solarpaneel nach Anspruch 1, **dadurch gekennzeichnet, dass** die Einrichtungen (2-702) zum Aufnehmen von Sonnenenergie aus Photovoltaikzellen bestehen.

3. Solarpaneel nach Anspruch 2, **dadurch gekennzeichnet, dass** es zumindest einen abgedichteten elektrischen Verbinder (11-711) enthält, der den elektrischen Anschluss der Photovoltaikzellen gestattet.

4. Solarpaneel nach einem der Ansprüche 1 bis 3, **dadurch gekennzeichnet, dass** es in Draufsicht die Form eines Parallelogramms und eine Fläche von weniger als 4 m², insbesondere zwischen 1 und 2 m², hat.

5. Solarpaneel nach einem der Ansprüche 1 bis 4, **dadurch gekennzeichnet, dass** die Schwimmeinrichtungen (9, 209, 303, 415, 515, 615, 719) gleichmäßig unter der Oberseite verteilt sind.

6. Solarpaneel nach einem der Ansprüche 1 bis 5, **dadurch gekennzeichnet, dass** die Schwimmeinrichtungen (9, 106, 209, 303, 415, 515, 615, 719) am Umfang der Oberseite verteilt sind.

7. Solarpaneel nach einem der Ansprüche 1 bis 6, **dadurch gekennzeichnet, dass** die schwimmfähige Struktur einen Rahmen (4, 104, 204, 204') enthält, in dem von unten nach oben zumindest eine Tragplatte (8, 208), insbesondere aus Glasfaser, zumindest eine schwimmfähige Platte (9, 209), insbesondere aus Polymer, und eine Schicht von Einrichtungen (2 - 702) zum Aufnehmen von Sonnenenergie gestapelt sind.

8. Solarpaneel nach einem der vorangehenden Ansprüche, **dadurch gekennzeichnet, dass** es Stoßdämpfer (106, 206) enthält, die sich am Umfang des Paneels (1, 201) befinden, wobei diese Dämpfer insbesondere schwimmfähig sind und aus Polyurethan bestehen.

9. Solarpaneel nach einem der vorangehenden Ansprüche, **dadurch gekennzeichnet, dass** es Befestigungseinrichtungen (10-710) enthält, die es ermöglichen, mehrere Solarpanelle desselben Typs miteinander zu verbinden.

10. Solaranlage, **dadurch gekennzeichnet, dass** sie eine Zusammenfügung von mehreren Solarpaneelen (1-701) nach einem der Ansprüche 1 bis 9 enthält, wobei die einzeln schwimmfähigen Paneele durch Bilden eines Netzes nebeneinander angeordnet sind, das insbesondere die Form eines Quadrats oder eines Rechtecks hat.

11. Solaranlage nach Anspruch 10, **dadurch gekennzeichnet, dass** die Paneele (1-701) direkt miteinander über ein System von Seilen, Kabeln oder Gurten verbunden sind, die deren Rahmen (4, 104, 204, 304) oder deren Tragplatte (618, 718) oder deren Stoßdämpfer (106, 206) verbinden.

12. Solaranlage nach Anspruch 11, **dadurch gekennzeichnet, dass** die Paneele über ihren Rahmen (4, 104, 204, 304) oder ihre Tragplatte (618, 718) oder ihre Stoßdämpfer (106, 206) an einem gemeinsamen Netz (21, 25) von Kabeln, Seilen oder Gurten befestigt sind.

13. Solaranlage nach einem der Ansprüche 10 bis 12, **dadurch gekennzeichnet, dass** sie Einrichtungen zum umfänglichen Halten (20) enthält, die sich um die Anordnung von Solarpaneelen (1-701) herum befinden, so dass sie diese mit einer im Wesentlichen flachen Anordnung von nebeneinander angeordneten Paneelen (1-701) festlegen.

14. Solaranlage nach Anspruch 13, **dadurch gekennzeichnet, dass** die Einrichtungen zum umfänglichen Halten (20) aus mehreren Schwimmbojen bestehen, die durch ein System von Unterwassermassen (28) festgelegt sind, insbesondere vier Schwimmbojen, die sich an den vier Ecken einer Anordnung von Solarpaneelen (1-701) mit quadratischer oder rechteckiger Form befinden.

15. Solaranlage nach Anspruch 13 oder 14, **dadurch gekennzeichnet, dass** zumindest eine Einrichtung zum umfänglichen Halten (20) einen Stromrichter zum Verarbeiten von Strom aus Photovoltaik-Solarpaneelen (1-701) durch geeignete Leitungseinrichtungen aufweist, wobei dieser Stromrichter den Strom in ein von der Solaranlage entferntes Stromnetz einspeist.

## Claims

1. Solar panel (1-107) comprising solar power collecting means (2-702), such as solar collectors or photovoltaic cells, the panel also comprising an upper face, in which the panel comprises a unitary buoyant structure on which the solar power collecting means (2-702) are mounted, the latter being incorporated into a solar module (3-703) arranged, in particular flat, on the buoyant structure, the panel (1-107) having, in a direction perpendicular to the upper face, a substantially constant thickness at least in a peripheral region of the panel (1-107), **characterized in that** the buoyant structure is adapted to position the upper face in a flush manner with the level of the surrounding water, in calm water.

2. Solar panel according to claim 1, **characterized in that** the solar power collecting means (2-702) are constituted by photovoltaic cells.

3. Solar panel according to claim 2, **characterized by** comprising at least one watertight electrical connector (11-711), allowing the photovoltaic cells to be electrically connected.

4. Solar panel according to any one of claims 1 to 3, **characterized by** having in a top view the general shape of a parallelogram and a surface area less than 4 m², in particular comprised between 1 and 2 m².

5. Solar panel according to any one of claims 1 to 4, **characterized in that** the buoyancy means (9, 209, 303, 415, 515, 615, 719) are uniformly distributed below the upper face.

6. Solar panel according to any one of claims 1 to 5, **characterized in that** the buoyancy means (9, 106, 209, 303, 415, 515, 615, 719) are distributed on the periphery of the upper face.

7. Solar panel according to any one of claims 1 to 6, **characterized in that** the buoyant structure comprises a chassis (4, 104, 204, 204') in which are stacked, from bottom to top, at least one support plate (8, 208), in particular made of fibreglass, at least one buoyant slab (9, 209), in particular made of polymer, and a layer of solar power collecting means (2-702).

8. Solar panel according to any one of the preceding claims, **characterized by** comprising shock absorbing fenders (106, 206) situated on the periphery of the panel (1, 201), these fenders being in particular buoyant and made of polyurethane.

9. Solar panel according to any one of the preceding claims, **characterized by** comprising attachment means (10-710) allowing several solar panels of the same type to be secured together.

10. Solar power plant **characterized by** comprising an assembly of several solar panels (1-701) according to any one of claims 1 to 9, the individually buoyant panels being juxtaposed to each other forming a net, having in particular the general shape of a square or rectangle.

11. Solar power plant according to claim 10, **characterized in that** the panels (1-701) are secured directly to each other by means of a system of cords, cables or straps connecting their chassis (4, 104, 204, 304) or support plate (618, 718), or their shock absorbing fenders (106, 206).

12. Solar power plant according to claim 11, **characterized in that** the panels are secured on a common net (21, 25) of cables, cords or straps, by means of their chassis (4, 104, 204, 304) or support plate (618, 718) or their shock absorbing fenders (106, 206).

13. Solar power plant according to any one of claims 10 to 12, **characterized by** comprising peripheral retaining means (20) situated around the set of solar panels (1-701) so as to immobilize it with a substantially flat arrangement of the juxtaposed panels (1-701).

14. Solar power plant according to claim 13, **characterized in that** the peripheral retaining means (20) are constituted by several flotation buoys immobilized by a system of submerged weights (28), in particular four flotation buoys situated at the four corners of a set of solar panels (1-701) having a generally square or rectangular shape.

15. Solar power plant according to claim 13 or 14, **characterized in that** at least one peripheral retaining means (20) incorporates a static converter for the conversion of the electricity arriving from the solar panels (1-701) of photovoltaic type by suitable conducting means, said converter conveying the electricity to an electricity network remote from the solar power plant.
